(19) Europäisches Patentamt
European Patent Office
Office européen des brevets

(11) **EP 1 754 266 B1**

(12) **EUROPÄISCHE PATENTSCHRIFT**

(45) Veröffentlichungstag und Bekanntmachung des Hinweises auf die Patenterteilung:
**06.11.2013 Patentblatt 2013/45**

(21) Anmeldenummer: **05746347.3**

(22) Anmeldetag: **17.05.2005**

(51) Int Cl.:
**H01L 35/18** *(2006.01)* **H01L 35/22** *(2006.01)*

(86) Internationale Anmeldenummer:
**PCT/EP2005/005344**

(87) Internationale Veröffentlichungsnummer:
**WO 2005/114757 (01.12.2005 Gazette 2005/48)**

(54) **NEUE TERNÄRE HALBLEITENDE LEGIERUNGEN MIT BANDLÜCKEN KLEINER ALS 0,8 eV**

NOVEL TERNARY SEMICONDUCTING ALLOYS HAVING BAND GAPS SMALLER 0.8 EV

NOUVEAUX ALLIAGES SEMI-CONDUCTEURS TERNAIRES A BANDES INTERDITES INFERIEURES A 0,8 EV

(84) Benannte Vertragsstaaten:
**AT BE BG CH CY CZ DE DK EE ES FI FR GB GR HU IE IS IT LI LT LU MC NL PL PT RO SE SI SK TR**

(30) Priorität: **21.05.2004 DE 102004025485**

(43) Veröffentlichungstag der Anmeldung:
**21.02.2007 Patentblatt 2007/08**

(73) Patentinhaber: **BASF SE**
**67056 Ludwigshafen (DE)**

(72) Erfinder:
• **STERZEL, Hans-Josef**
**67125 Dannstadt-Schauernheim (DE)**
• **KÜHLING, Klaus**
**67158 Ellerstadt (DE)**

(56) Entgegenhaltungen:
EP-A- 0 821 417    CH-A- 381 292
US-A- 3 020 326    US-A- 3 454 370
US-B1- 6 225 550

• KAJIKAWA T ET AL: "Thermoelectric properties of sintered magnesium compounds" THERMOELECTRICS, 1996., FIFTEENTH INTERNATIONAL CONFERENCE ON PASADENA, CA, USA 26-29 MARCH 1996, NEW YORK, NY, USA,IEEE, US, 26. März 1996 (1996-03-26), Seiten 128-132, XP010198951 ISBN: 0-7803-3221-0
• RIFFEL M ET AL: "Mechanically alloyed Mg2Si1-xSnx solid solutions as thermoelectric materials" THERMOELECTRICS, 1996., FIFTEENTH INTERNATIONAL CONFERENCE ON PASADENA, CA, USA 26-29 MARCH 1996, NEW YORK, NY, USA,IEEE, US, 26. März 1996 (1996-03-26), Seiten 133-136, XP010198952 ISBN: 0-7803-3221-0
• ZAITSEV V K ET AL: "THERMOELECTRIC PROPERTIES OF SOME HETEROPHASE MATERIALS BASED ON MANGANIC SILICIDE" APPLIED SOLAR ENERGY (GELIOTEKHNIKA), ALLERTON PRESS INC, NEW YORK, US, Bd. 25, Nr. 1, Januar 1989 (1989-01), Seiten 15-19, XP000086646 ISSN: 0003-701X
• VERBRUGGE D M ET AL: "LIQUID SEMICONDUCTOR AND THERMOELECTRIC POWER GENERATION: MG-SB" JOURNAL OF PHYSICS D. APPLIED PHYSICS, IOP PUBLISHING, BRISTOL, GB, Bd. 26, Nr. 10, 1993, Seiten 1722-1726, XP000955274 ISSN: 0022-3727

**EP 1 754 266 B1**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft ternäre halbleitende Legierungen, diese enthaltende thermoelektrische Generatoren und Peltier-Anordnungen und Verfahren zur Herstellung dieser ternären halbleitenden Legierungen.

Thermoelektrische Generatoren und Peltier-Anordnungen als solche sind seit langem bekannt. p- und n-dotierte Halbleiter, die auf einer Seite erhitzt und auf der anderen Seite gekühlt werden, transportieren elektrische Ladungen durch einen äußeren Stromkreis. Durch diese thermoelektrischen Generatoren kann an einem Verbraucher im Stromkreis elektrische Arbeit verrichtet werden. Peltier-Anordnungen kehren den zuvor beschriebenen Prozess um.

Einen guten Überblick über thermoelektrische Effekte und Materialien gibt z. B. Cronin B. Vining, ITS Short Course on Thermoelectricity, Nov. 8, 1993 Yokohama, Japan.

Gegenwärtig werden thermoelektrische Generatoren in Raumsonden zur Erzeugung von Gleichströmen, für den kathodischen Korrosionsschutz von Pipelines, zur Ernergieversorgung von Leucht- und Funkbojen sowie zum Betrieb von Radios und Fernsehapparaten eingesetzt. Die Vorteile der thermoelektrischen Generatoren liegen in ihrer äußersten Zuverlässigkeit: So arbeiten sie unabhängig von atmosphärischen Bedingungen wie Luftfeuchte; es erfolgt kein störungsanfälliger Stofftransport, sondern nur ein Ladungstransport; der Betriebsstoff wird kontinuierlich - auch katalytisch ohne freie Flamme - verbrannt, wodurch nur geringe Mengen an CO. $NO_x$ und unverbranntem Betriebsstoff frei werden; es sind beliebige Betriebsstoffe einsetzbar von Wasserstoff über Erdgas, Benzin, Kerosin, Dieselkraftstoff bis zu biologisch erzeugten Kraftstoffen wie Rapsölmethylester.

Damit passt sich die thermoelektrische Energiewandlung äußerst flexibel in künftige Bedürfnisse wie Wasserstoffwirtschaft oder Energieerzeugung aus regenerativen Energien ein.

Eine besonders attraktive Anwendung wäre der Einsatz zur Wandlung in elektrische Energie in elektrisch betriebenen Fahrzeugen. Insbesondere bräuchte hierfür keine Änderung am vorhandenen Tankstellennetz vorgenommen zu werden.

Thermoelektrisch aktive Materialien werden im Wesentlichen anhand ihres Wirkungsgrades bewertet. Kennzeichnend für thermoelektrische Materialien ist diesbezüglich der so genannte Z-Faktor (figure of merit):

$$Z = \frac{S^2 \cdot \sigma}{\kappa}$$

mit dem Seebeck-Koeffizienten S, der elektrischen Leitfähigkeit $\sigma$ und der Wärmeleitfähigkeit $\kappa$. Gesucht dabei werden thermoelektrische Materialien, die eine möglichst geringe Wärmeleitfähigkeit, eine möglichst große elektrische Leitfähigkeit und einen möglichst großen Seebeck-Koeffizienten aufweisen, so dass der figure of merit einen möglichst hohen Wert annimmt.

Eine genauere Analyse ergibt, dass der Wirkungsgrad $\eta$ sich ergibt aus

$$\eta = \frac{T_{hoch} - T_{niedrig}}{T_{hoch}} \cdot \frac{M-1}{M + \frac{T_{niedrig}}{T_{hoch}}}$$

mit

$$M = \left[ 1 + \frac{Z}{2} \left( T_{hoch} + T_{niedrig} \right) \right]^{\frac{1}{2}}.$$

(siehe auch Mat. Sci. and Eng. B29 (1995) 228).

Das Ziel ist damit, ein Material mit einem möglichst hohen Wert für Z und hoher realisierbarer Temperaturdifferenz bereitzustellen. Aus der Sicht der Festkörperphysik sind hierbei viele Probleme zu bewältigen:

Materialien mit hoher elektrischer Leitfähigkeit weisen meist gleichzeitig eine hohe Wärmeleitfähigkeit auf (Wiedemann - Franzsches Gesetz), wodurch Z nicht günstig beeinflusst werden kann. Gegenwärtig eingesetzte Materialien wie $Bi_2Te_3$, PbTe oder SiGe stellen schon Kompromisse dar. So wird die elektrische Leitfähigkeit durch Legieren weniger herabgesetzt als die Wärmeleitfähigkeit. Deshalb setzt man vorzugsweise Legierungen ein wie z. B. $(Bi_2T_3)_{90}$ $(Sb_2T_3)_5$ $(Sb_2Se_3)_5$ oder $Bi_{12}Sb_{23}Te_{65}$, wie sie in der US 5, 448, 109 beschrieben sind.

KAJIKAWA T ET AL: "Thermoelectric properties of sintered magnesium compounds" THERMOELECTRICS, 1996., FIFTEENTH INTERNATIONAL CONFERENCE ON PASADENA, CA, USA 26-29 MARCH 1996, NEW YORK, NY, USA,IEEE, US, 26. März 1996 (1996-03-26), Seiten 128-132, XP010198951 ISBN: 0-7803-3221-0 offenbart thermoelektrische Eigenschaften von gesinterten Magnesiumverbindungen. In der Einleitung auf Seite 128 werden intermetallische Magnesiumverbindungen wie Magnesiumsilicid, Magnesiumstannid und Magnesiumgermanid und ihre festen Lösungen offenbart. Des Weiteren wird eine Verbindung der Formel $Mg_2Si_{1-x}Ge_x$ offenbart.

US 3 454 370 A offenbart ternäre halbleitende Materialien, beispielsweise ZnFe2Sb2, ZnCo2Sb2, Zn2CoSb2, MgMn2Sb2, MgCo2Sb2 und FeCd2As2, und deren Verwendung in Photozellen, Thermoelementen und Stromgleichrichtern.

US 6 225 550 B1 offenbart thermoelektrische Materialien entsprechend der allgemeinen Formel Ax-MyBz wobei A ausgewählt ist aus einer Gruppe von Metallen und B ausgewählt ist aus einer weiteren Gruppe bestehend aus Halbmetallen oder Nicht-Metallen. Des Weiteren können diese Verbindungen mit einem Metall ausgewählt aus den Übergangsmetallen dotiert sein, sodass eine Verbindung der allgemeinen Formel MgMSb entsteht. M ist dabei ausgewählt aus der Gruppe bestehend aus Cu, Ag, Mn, Fe, Co, Ni, Zn und Mischungen davon. Für thermoelektrische Materialien mit hohem Wirkungsgrad sind vorzugsweise noch weitere Randbedingungen zu erfüllen. So müssen sie temperaturstabil sein, um bei Arbeitstemperaturen von 1.000 bis 1.500 K über Jahre ohne wesentlichen Wirkungsgradverlust arbeiten zu können. Dies bedingt sowohl hochtemperaturstabile Phasen an sich, eine stabile Phasenzusammensetzung, wie auch eine zu vernachlässigende Diffusion von Legierungsbestandteilen in die anliegenden Kontaktmaterialien.

Neue viel versprechende thermoelektrische Materialien stehen darüber hinaus in dem Spannungsfeld einer moderaten Bandlücke: So sind thermoelektrische Materialien, die nur eine geringe Bandlücke aufweisen, unerwünscht, da sie unter den gewählten Bedingungen leicht degenerieren bzw. intrinsisch werden, wobei es zu einem gleichzeitigen Anstieg der elektrischen und thermischen Leitfähigkeit des Materials kommt. Dieser Anstieg wirkt sich negativ auf den figure of merit aus. Gleichzeitig sollte die Bandlücke von thermoelektrischen Materialien auch nicht zu groß sein, da andernfalls die Energie, die erforderlich ist, um ein Elektron in ein Leitungsband zu heben, zu groß ist. Unter'dem Gesichtspunkt von moderaten Bandlücken haben sich thermoelektrische Materialien als vorteilhaft herausgestellt, die Bandlücken kleiner 0,8 eV aufweisen.

Beispiele geeigneter thermoelektrischer Materialien, die moderate Bandlücken aufweisen, sind in WO 03/023871 A2 erwähnt.

Es besteht jedoch weiterhin Bedarf an thermoelektrisch aktiven Materialien, die eine moderate Bandlücke und einen hohen Wirkungsgrad aufweisen sowie ein für unterschiedliche Anwendungsbereiche geeignetes Eigenschaftsprofil zeigen. Insbesondere besteht Bedarf an thermoelektrischen Materialien mit moderaten Bandlücken, die keine Elemente wie Germanium, Indium, Gallium, Selen oder Tellur enthalten, deren weltweite Produktion stark begrenzt ist. Neue thermoelektrische Materialien sollten darüber hinaus auch keine Elemente enthalten, die toxische bzw. ökotoxische Eigenschaften haben wie Thallium, Quecksilber, Cadmium oder Selen.

Daher bestand für die die vorliegende Erfindung die Aufgabe, thermoelektrische Generatoren oder Peltier-Anordnungen bereitzustellen, deren thermoelektrische Materialien Bandlücken unterhalb 0,8 eV und einen hohen Wirkungsgrad aufweisen sowie die zuvor erwähnten nachteiligen Elemente nicht enthalten.

Erfindungsgemäß wird diese Aufgabe gelöst durch einen thermoelektrischen Generator oder eine Peltier-Anordnung mit einer ternären halbleitenden Legierung als thermoelektrisches Material. Die ternäre halbleitende Legierung ist dann dadurch gekennzeichnet, dass sie sich von zwei binären Stammverbindungen ableitet, wobei ein Element der ternären halbleitenden Legierung in den beiden binären Stammverbindungen enthalten ist, und die binären Stammverbindungen sind ausgewählt aus der Gruppe, bestehend aus $Mg_2Sn$, $Mg_3Sb_2$, $Mg_3Bi_2$, $Mg_2Pb$, $Mg_3Bi_2$, $CaSi_2$, $Ca_{1,1}Sb$, $Ca_5Bi_3$, $Ca_2Pb$, $CoSi_2$, $CoSb$, $CoSn$, $CrSi_2$, $CrSb$, $AlSi$, $AlSb$, $BaSi_2$, $Bi_2Ba_3$, $Ba_2Pb$, $Ba_5Sb_3$, $Ba_5Sb_4$, $BaSb_3$, $Ba_2Sb$, $SrSi_2$, $Bi_2Sr_3$, $SbSr$, $Sr_2Pb$, $Mg_2Si$, $MnSi_{1,73}$, $Mn_2Sb$, $Mn_2Sn$, $NiSi_2$, $Ni_3Sn_2$ und $NiSb$, und das Element der ternären Verbindungen das in den beiden binären Stammverbindungen enthalten ist, ausgewählt ist aus der Gruppe, bestehend aus Magnesium, Calcium, Kobalt, Chrom, Aluminium, Barium, Strontium, Mangan und Nickel.

Ternäre halbleitende Legierungen (feste Lösungen, Halbleitermaterialien) im Sinne der vor-liegenden Erfindung ergeben sich somit aus der Kombination von mindestens zwei binären Stammverbindungen, wobei ein Element der ternären halbleitenden Legierung in den beiden binären Stammverbindungen enthalten ist. Die binären Stammverbindungen zeichnen sich vorzugsweise durch hohe Schmelzpunkte, kongruente Schmelzen und vergleichsweise hohe Seebeck-Koeffizienten aus. Zudem weisen sie alle Halbleitereigenschaften auf, beispielsweise einen Anstieg der elektrischen Leitfähigkeit bei Temperaturerhöhung.

Im Rahmen der vorliegenden Erfindungen werden diese binären Stammverbindungen eingesetzt, um aus deren Kombinationen ternäre halbleitende Legierungen mit hohem Z - Wert und Bandlücken von weniger als 0,8 eV zu erhalten.

In einer besonders bevorzugten Ausführungsform der vorliegenden Erfindung ist die ternäre halbleitende Legierung ausgewählt aus der Gruppe, bestehend aus

$Mg_2Sn \cdot n\ Mg_3Sb_2$

$Mg_2Sn \cdot n\ Mg_3Bi_2$

$Mg_2Sn \cdot n\ Mg_2Pb$

$Mg_2Pb\ n\ Mg_3Sb_2$

$Mg_2Pb \cdot n\ Mg_3Bi_2$

$CaSi_2 \cdot n\ Ca_{1,1}Sb$

$CaSi2 \cdot nCa_5Bi_3$

$CaSi_2 \cdot n\ Ca_2Pb$

$CoSi_2 \cdot n\ CoSb$

$CoSi_2 \cdot n\ CoSn$

$CrSi_2 \cdot n\ CrSb$

$AlSi \cdot n\ AlSb$

$BaSi_2 \cdot n\ Bi_2Ba_3$

$BaSi_2 \cdot n\ Ba_2Pb$

$BaSi_2 \cdot n\ Ba_5Sb_3$

$BaSi_2 \cdot n\ Ba_5Sb_4$

$BaSi_2 \cdot n\ BaSb_3$

$BaSi_2 \cdot n\ Ba_2Sb$
$SrSi_2 \cdot n\ Bi_2Sr_3$
$SrSi_2 \cdot n\ SbSr$
$SrSi_2 \cdot n\ Sr_2Pb$
$Mg_2Si \cdot n\ Mg_3Sb_2$
$Mg_2Si \cdot n\ Mg_3Bi_2$
$Mg_2Si \cdot n\ Mg_2Pb$
$MnSi_{1,73} \cdot n\ Mn_2Sb$
$MnSi_{1,73} \cdot n\ Mn_2Sn$
$NiSi_2 \cdot n\ Ni_3Sn_2$
$NiSi_2 \cdot n\ NiSb$,

wobei n 0,2 bis 5, vorzugsweise 0,2 bis 2,0 beträgt.

Besonders bevorzugte ternäre halbleitende Legierungen sind $Mg_2Sn \cdot n\ Mg_3Sb_2$ und $Mg_2Sn \cdot n\ Mg_3Bi_2$ mit n = 0,2 bis 5, insbesondere 0,5 bis 2,0.

Die zuvor beschriebenen ternären halbleitenden Legierungen weisen eine geringe thermische Leitfähigkeit, im Allgemeinen kleiner als 50 mW/cm · K, auf.

Die vorliegenden ternären halbleitenden Legierungen können ohne weitere Dotierung eingesetzt werden. Alternativ können sie aber auch zusätzlich dotiert sein. Wenn die ternären halbleitenden Legierungen dotiert sind, so beträgt der Anteil an Dotierungselementen vorzugsweise bis zu 1,0 Atom-% in der Legierung oder $10^{18}$ bis $10^{21}$ Ladungsträger pro Kubikzentimeter. Höhere Ladungsträgerkonzentrationen bewirken nachteilige Rekombinationen und damit eine reduzierte Ladungsbeweglichkeit. Dotiert wird mit Elementen, die einen Elektronenüber- oder -unterschuss im Kristallgitter bewirken. Geeignete Dotiermaterialien für p-Halbleiter sind beispielsweise die folgenden Elemente: Stickstoff, Schwefel, Phosphor, Arsen, Antimon, Bismut, Sauerstoff, Chlor, Brom und Iod sowie Gemische davon. Geeignete Dotiermaterialien für n-Halbleiter sind die Elemente Kupfer, Silber, Natrium, Rubidium, Cesium, Bor, Silizium, Blei, Beryllium, Magnesium, Calcium, Strontium, Barium und deren Gemische.

Eine weitere Möglichkeit der Dotierung ergibt sich dadurch, dass man gezielt durch unter- oder überstöchiometrische Zusammensetzungen Löcher oder Elektronen in die Materialien einbringt und sich damit einen zusätzlichen Dotierschritt erspart.

Durch die Wahl geeigneter binärer Stammverbindungen und gegebenenfalls einer geeigneten Dotierung werden ternäre halbleitende Legierungen erhalten, die einen Seebeck-Koeffizienten S von größer 200 $\mu$V/K aufweisen. Die elektrische Leitfähigkeit $\sigma$ der thermoelektrischen Materialien beträgt vorzugsweise mehr als 100 S · cm$^{-1}$.

Die vorliegende Erfindung betrifft darüber hinaus die zuvor beschriebenen ternären halbleitenden Legierungen, deren Verwendung in thermoelektrischen Generatoren oder Peltier-Anordnungen sowie Verfahren zu ihrer Herstellung.

Die erfindungsgemäßen Materialien werden vorzugsweise hergestellt, indem man die binären Stammverbindungen gemeinsam aufschmilzt, wobei mindestens 40 Gew.-%, vorzugsweise mindestens 50 Gew.-%, insbesondere mindestens 60 Gew.-%, der Mischung, entsprechend den Schmelztemperaturen der binären Stammverbindungen aufgeschmolzen werden. Der dabei nicht aufgeschmolzene Anteil der binären Stammverbindungen löst sich im Allgemeinen in dem geschmolzenen Anteil der binären Stammverbindungen. Alternativ ist es auch möglich, die Schmelztemperatur nach der am höchsten schmelzenden Komponenten zu richten.

Zum Aufschmelzen der binären Stammverbindungen werden vorzugsweise Widerstandsöfen oder Induktionsöfen verwendet, wobei die Art des Tiegelmaterials des Ofens sich nach den eingesetzten binären Stammverbindungen bzw. nach den eingesetzten Elementen richtet. Bevorzugt ist dabei, dass das Tiegelmaterial sich im Wesentlichen inert gegenüber den eingesetzten binären Stammverbindungen bzw. den eingesetzten Elementen verhält.

Wenn die binären Stammverbindungen keine Erdalkalimetalle enthalten, so eignet sich beispielsweise Quarz als Tiegelmaterial. Graphit ist in Gegenwart von Silizium bei Temperaturen unterhalb 1.500 °C geeignet, weil sich unter diesen Bedingungen noch kein Siliziumcarbid bildet. Sind zur Synthese der erfindungsgemäßen ternären halbleitenden Legierungen erhöhte Temperaturen, beispielsweise höher als 1300 °C, erforderlich, so kann in Abwesenheit der Elemente Kobalt, Nickel und Mangan auch mit Tantal als Tiegelmaterial gearbeitet werden.

Das Aufschmelzen erfolgt im Allgemeinen unter einer inerten Gasatmosphäre, vorzugsweise eines Edelgases oder im Vakuum.

Die Aufschmelz- und Reaktionszeit ist unterschiedlich und muss für jede Kombination von binären Stammverbindungen experimentell ermittelt werden. Zusätzlichen Einfluss auf die Aufschmelz- und Reaktionszeit haben die Art der verwendeten Öfen sowie deren Arbeitsfrequenzen. Wird beispielsweise in Induktionsöfen gearbeitet, deren Arbeitsfrequenz im Bereich von 1 bis 10 kHz liegt, so wird die Schmelze durch die Magnetfelder derart gut bewegt, dass nach Erreichen der Reaktionstemperatur mit Haltezeiten von 5 bis 30 Minuten zu rechnen ist.

Die erfindungsgemäßen thermoelektrischen Generatoren können zur Erzeugung von Strom verwendet werden. Dabei wird eine Seite des Halbleitermaterials erwärmt, während die andere gekühlt wird. Die hierzu erforderliche Wärmequelle kann beliebig sein. So kann es sich beispielsweise um Wärme durch Solareinstrahlung, Verbrennung von konventionellen Kraftstoffen, Biomasse oder Autoabgase handeln.

**Patentansprüche**

1. Thermoelektrischer Generator oder Peltier-Anordnung mit einer ternären halbleitenden Legierung als thermoelektrisches Material, wobei sich die ternäre halbleitende Legierung von zwei binären Stammverbindungen ableitet, wobei ein Element der ternären halbleitenden Legierung in den beiden binären Stammverbindungen enthalten ist, und die binären Stammverbindungen ausgewählt sind aus der Gruppe, bestehend aus $Mg_2Sn$, $Mg_3Bi_2$, $CaSi_2$, $Ca_{1.1}Sb$, $Ca_5Bi_3$, $Ca_2Pb$, $CoSi_2$, $CoSb$, $CoSn$, $CrSi_2$, $CrSb$, $AlSi$, $AlSb$, $BaSi_2$, $Bi_2Ba_3$, $Ba_2Pb$, $Ba_5Sb_3$, $Ba_5Sb_4$, $BaSb_3$, $Ba_2Sb$, $SrSi_2$, $Bi_2Sr_3$, $SbSr$, $Sr_2Pb$, $Mg_2Si$, $Mg_3Sb_2$, $Mg_3Bi_2$, $Mg_2Pb$, $MnSi_{1.73}$, $Mn_2Sb$, $Mn_2Sn$, $NiSi_2$, $Ni_3Sn_2$ und $NiSb$, und das Element der ternären halbleitenden Legierung, das in den beiden binären Stammverbindungen enthalten ist, ausgewählt ist aus der Gruppe, bestehend aus Magnesium, Calcium, Kobalt, Chrom, Aluminium, Barium, Strontium, Mangan und Nickel.

2. Thermoelektrischer Generator oder Peltier-Anordnung nach Anspruch 1 wobei die ternäre halbleitende Legierung ausgewählt ist aus der Gruppe, bestehend aus

$Mg_2Sn \cdot n\ Mg_3Sb_2$
$Mg_2Sn \cdot n\ Mg_3Bi_2$
$Mg_2Sn \cdot n\ Mg_2Pb$
$Mg_2Pb \cdot n\ Mg_3Sb_2$
$Mg_2Pb \cdot n\ Mg_3Bi_2$
$CaSi_2 \cdot n\ Ca_{1.1}Sb$
$CaSi_2 \cdot n\ Ca_5Bi_3$
$CaSi_2 \cdot n\ Ca_2Pb$
$CoSi_2 \cdot n\ CoSb$
$CoSi_2 \cdot n\ CoSn$
$CrSi_2 \cdot n\ CrSb$
$AlSi \cdot n\ AlSb$
$BaSi_2 \cdot n\ Bi_2Ba_3$
$BaSi_2 \cdot n\ Ba_2Pb$
$BaSi_2 \cdot n\ Ba_5Sb_3$
$BaSi_2 \cdot n\ Ba_5Sb_4$
$BaSi_2 \cdot n\ BaSb_3$
$BaSi_2 \cdot n\ Ba_2Sb$
$SrSi_2 \cdot n\ Bi_2Sr_3$
$SrSi_2 \cdot n\ SbSr$
$SrSi_2 \cdot n\ Sr_2Pb$
$Mg_2Si \cdot n\ Mg_3Sb_2$
$Mg_2Si \cdot n\ Mg_3Bi_2$
$Mg_2Si \cdot n\ Mg_2Pb$
$MnSi_{1.73} \cdot n\ Mn_2Sb$
$MnSi_{1.73} \cdot n\ Mn_2Sn$
$NiSi_2 \cdot n\ Ni_3Sn_2$
$NiSi_2 \cdot n\ NiSb$,

wobei n 0,2 bis 5 beträgt.

3. Ternäre halbleitende Legierung, wie in Anspruch 1 oder 2 definiert.

4. Verwendung der ternären halbleitenden Legierungen gemäß Anspruch 3 in thermoelektrischen Elementen und Peltier-Anordnungen.

5. Verfahren zur Herstellung von ternären halbleitenden Legierungen gemäß Anspruch 3 durch Aufschmelzen der binären Stammverbindungen, wobei mindestens 60 Gew.-%.
der Mischung, entsprechend den Schmelztemperaturen der binären Stammverbindungen, aufgeschmolzen werden.

6. Verfahren nach Anspruch 5, wobei zum Aufschmelzen der binären Stammverbindungen Widerstandsöfen oder Induktionsöfen verwendet werden.


**Claims**

1. A thermoelectric generator or Peltier arrangement having a ternary semiconductive alloy as the thermoelectric material, wherein the ternary semiconductive alloy is derived from two binary parent compounds, one element of the ternary semi-conductive alloy being present in both binary parent compounds, and wherein the binary parent compounds are selected from the group consisting of $Mg_2Sn$, $Mg_3Bi_2$, $CaSi_2$, $Ca_{1.1}Sb$, $Ca_5Bi_3$, $Ca_2Pb$, $CoSi_2$, $CoSb$, $CoSn$, $CrSi_2$, $CrSb$, $AlSi$, $AlSb$, $BaSi_2$, $Bi_2Ba_3$, $Ba_2Pb$, $Ba_5Sb_3$, $Ba_5Sb_4$, $BaSb_3$, $Ba_2Sb$, $SrSi_2$, $Bi_2Sr_3$, $SbSr$, $Sr_2Pb$, $Mg_2Si$, $Mg_3Sb_2$, $Mg_3Bi_2$, $Mg_2Pb$, $MnSi_{173}$, $Mn_2Sb$, $Mn_2Sn$, $NiSi_2$, $Ni_3Sn_2$ and $NiSb$, and wherein the element of the ternary semiconductive alloy which is present in both binary parent compounds is selected from the group consisting of magnesium, calcium, cobalt, chromium, aluminum, barium, strontium, manganese and nickel.

2. The thermoelectric generator or Peltier arrangement according to claim 1, wherein the ternary semiconductive alloy is selected from the group consisting of $Mg_2Sn \cdot n\ Mg_3Sb_2$
$Mg_2Sn \cdot n\ Mg_3Bi_2$
$Mg_2Sn \cdot n\ Mg_2Pb$
$Mg_2Pb \cdot n\ Mg_3Sb_2$
$Mg_2Pb \cdot n\ Mg_3Bi_2$
$CaSi_2 \cdot n\ Ca_{1.1}Sb$
$CaSi_2 \cdot n\ Ca_5Bi_3$
$CaSi_2 \cdot n\ Ca_2Pb$
$CoSi_2 \cdot n\ CoSb$
$CoSi_2 \cdot n\ CoSn$
$CrSi_2 \cdot n\ CrSb$
$AlSi \cdot n\ AlSb$
$BaSi_2 \cdot n\ Bi_2Ba_3$
$BaSi_2 \cdot n\ Ba_2Pb$
$BaSi_2 \cdot n\ Ba_5Sb_3$
$BaSi_2 \cdot n\ Ba_5Sb_4$
$BaSi_2 \cdot n\ BaSb_3$
$BaSi_2 \cdot n\ Ba_2Sb$

$SrSi_2 \cdot n\ Bi_2Sr_3$
$SrSi_2 \cdot n\ SbSr$
$SrSi_2 \cdot n\ Sr_2Pb$
$Mg_2Si \cdot n\ Mg_3Sb_2$
$Mg_2Si \cdot n\ Mg_3Bi_2$
$Mg_2Si \cdot n\ Mg_2Pb$
$MnSi_{1.73} \cdot n\ Mn_2Sb$
$MnSi_{1.73} \cdot n\ Mn_2Sn$
$NiSi_2 \cdot n\ Ni_3Sn_2$
$NiSi_2 \cdot n\ NiSb$,
where n is from 0.2 to 5.

**3.** A ternary semiconductive alloy as defined in claim 1 or 2.

**4.** The use of the ternary semiconductive alloys according to claim 3 in thermoelectric elements and Peltier arrangements.

**5.** A process for producing ternary semiconductive alloys according to claim 3 by melting the binary parent compounds, at least 60% by weight of the mixture, depending on the melt temperatures of the binary parent compounds, being melted.

**6.** The process according to claim 5, wherein the binary parent compounds are melted using resistance ovens or induction ovens.

**Revendications**

**1.** Générateur thermoélectrique ou dispositif de Peltier présentant un alliage semi-conducteur ternaire comme matériau thermoélectrique, l'alliage ternaire semi-conducteur étant dérivé de deux composés souches binaires, un élément de l'alliage semi-conducteur ternaire étant contenu dans les deux composés souches binaires, et les composés souches binaires étant choisis dans le groupe constitué par $Mg_2Sn$, $Mg_3Bi_2$, $CaSi_2$, $Ca_{1.1}Sb$, $Ca_5Bi_3$, $Ca_2Pb$, $CoSi_2$, CoSb, CoSn, $CrSi_2$, CrSb, AlSi, AlSb, $BaSi_2$, $Bi_2Ba_3$, $Ba_2Pb$, $Ba_5Sb_3$, $Ba_5Sb_4$, $BaSb_3$, $Ba_2Sb$, $SrSi_2$, $Bi_2Sr_3$, SbSr, $Sr_2Pb$, $Mg_2Si$, $Mg_3Sb_2$, $Mg_3Bi_2$, $Mg_2Pb$, $MnSi_{1.73}$, $Mn_2Sb$, $Mn_2Sn$, $NiSi_2$, $Ni_3Sn_2$ et NiSb, et l'élément de l'alliage semi-conducteur ternaire, qui est contenu dans les deux composés souches binaires, étant choisi dans le groupe constitué par le magnésium, le calcium, le cobalt, le chrome, l'aluminium, le baryum, le strontium, le manganèse et le nickel.

**2.** Générateur thermoélectrique ou dispositif de Peltier selon la revendication 1, l'alliage semi-conducteur ternaire étant choisi dans le groupe constitué par

$Mg_2Sn * n\ Mg_3Sb_2$
$Mg_2Sn * n\ Mg_3Bi_2$

$Mg_2Sn * n\ Mg_2Pb$
$Mg_2Pb * n\ Mg_3Sb_2$
$Mg_2Pb * n\ Mg_3Bi_2$
$CaSi_2 * n\ Ca_{1.1}Sb$
$CaSi_2 * n\ Ca_5Bi_3$
$CaSi_2 * n\ Ca_2Pb$
$CoSi_2 * n\ CoSb$
$CoSi_2 * n\ CoSn$
$CrSi_2 * n\ CrSb$
$AlSi * n\ AlSb$
$BaSi_2 * n\ Bi_2Ba_3$
$BaSi_2 * n\ Ba_2Pb$
$BaSi_2 * n\ Ba_5Sb_3$
$BaSi_2 * n\ Ba_5Sb_4$
$BaSi_2 * n\ BaSb_3$
$BaSi_2 * n\ Ba_2Sb$
$SrSi_2 * n\ Bi_2Sr_3$
$SrSi_2 * n\ SbSr$
$SrSi_2 * n\ Sr_2Pb$
$Mg_2Si * n\ Mg_3Sb_2$
$Mg_2Si * n\ Mg_3Bi_2$
$Mg_2Si * n\ Mg_2Pb$
$MnSi_{1.73} * n\ Mn_2Sb$
$MnSi_{1.73} * n\ Mn_2Sn$
$NiSi_2 * n\ Ni_3Sn_2$
$NiSi_2 * n\ NiSb$,
n valant 0,2 à 5.

**3.** Alliage semi-conducteur ternaire, tel que défini dans la revendication 1 ou 2.

**4.** Utilisation des alliages semi-conducteurs ternaires selon la revendication 3 dans des éléments thermoélectriques et des dispositifs de Peltier.

**5.** Procédé pour la préparation d'alliages semi-conducteurs ternaires selon la revendication 3 par fusion des composés souches binaires, au moins 60% en poids du mélange étant fondus, conformément aux températures de fusion des composés souches binaires.

**6.** Procédé selon la revendication 5, des fours à résistance ou des fours à induction étant utilisés pour la fusion des composés souches binaires.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5448109 A
- US 3454370 A
- US 6225550 B1
- WO 03023871 A2

**In der Beschreibung aufgeführte Nicht-Patentliteratur**

- **CRONIN B. VINING.** *ITS Short Course on Thermoelectricity,* 08. November 1993
- *Mat. Sci. and Eng.,* 1995, vol. B29, 228
- **KAJIKAWA T et al.** Thermoelectric properties of sintered magnesium compounds. *THERMOELECTRICS, 1996., FIFTEENTH INTERNATIONAL CONFERENCE ON PASADENA,* 26. Marz 1996, ISBN 0-7803-3221-0, 128-132